# EUROPEAN PATENT SPECIFICATION

(11) **EP 1 829 990 B1**
(45) Date of publication and mention of the grant of the patent: **09.11.2016**
(21) Application number: 07101854.3
(22) Date of filing: 07.02.2007
(51) Int. Cl.: C23C 30/00, C23C 28/04, C23C 28/00

(54) **Coated cermet cutting tool and use thereof**
Beschichtetes Cermet-Schneidwerkzeug und seine Verwendung
Outil de coupe en cermet enrobé et son utilisation

(30) Priority: 03.03.2006 SE 0600483
(43) Date of publication of application: 05.09.2007
(73) Proprietor: Sandvik Intellectual Property AB, 811 81 Sandviken (SE)
(72) Inventor: Mikus, Marion, SE-127 30, Skärholmen (SE); Westergren, Kenneth, SE-129 35, Hägersten (SE); Åkesson Leif, SE-125 51, Älvsjö (SE); Martensson, Per, SE-131 33, Nacka (SE)
(74) Representative: Taquist, Henrik Lennart Emanuel

(56) References cited:
- EP-A- 0 947 594
- EP-A- 1 643 012
- EP-A2- 0 368 336
- JP-A- 2002 263 940
- JP-A- 2004 181 618
- JP-A- 2005 111 586
- JP-A- 2005 131 739
- JP-A- 2006 026 862

## Description

The present invention relates to a coated cermet cutting tool particularly useful for machining of cast iron work pieces such as nodular cast iron (NCI), compact graphite iron (CGI) and grey cast iron (GCI) at high cutting speed.

Cermets tools are used with good results in finishing operations of steel but, due to their brittleness, cermets tools are not used in high productivity machining operations together with large cutting depths and large feeds requiring increased toughness. In addition, cermets tools are not used in machining of cast irons, especially not in medium to roughing operations.

The various cast iron grades are machined with use of chemical vapour deposition (CVD) coated cemented carbide cutting tool inserts. Grey cast iron is also machined with silicon nitride based ceramic cutting tools. However ceramic tools are expensive because of the high manufacturing cost. It is therefore a desire if possible to replace ceramic tools with less expensive tools. The ceramic tools, such as based on silicon nitride, perform well in grey cast iron, however, show limited tool life in nodular cast iron. Thus conventional coated cemented carbide tools are used in nodular cast iron area.

However, there are demands from various machining industries for tools with higher productivity and longer tool life than that obtained by conventional coated cemented carbide.

Cemented carbide cutting tools coated with various types of hard CVD layers have been commercially available for years. Such tool coatings are generally built up by one Ti(C,N) and one Al₂O₃ hard layer where the Ti(C,N) is the innermost layer adjacent to the cemented carbide. The thickness of the individual layers is carefully chosen to suit different cutting applications and workpiece materials, e.g., cast iron and various steel grades. Coated cemented carbide tool inserts may be used for both continuous and interrupted cutting operations of various types of steels and cast irons.

US 6,007,909, discloses coated cutting tools comprising CVD 1-20 µm thick coating on a Ti based carbonitride cermet body, used in steel cutting, such as finishing operations with relatively small cutting depths. The coating should have compressive residual stresses of 100-800 MPa.

US 6,183,846 disclose a coated cutting tool including a hard coating on a surface of a base material of cemented carbide or cermet. The hard coating includes an inner layer on the base material, an intermediate layer on the inner layer and an outer layer on the intermediate layer. The inner layer with a thickness of 0.1 to 5 µm consists of a carbide, a nitride, a carbonitride, a carboxide, a carbo-oxinitride or a boronitride of Ti. The intermediate layer consists of Al₂O₃ with a thickness of 5 to 50 µm or ZrO₂ with a thickness of 0.5 to 20 µm. The outer layer with a thickness of 5 to 100 µm consists of a carbide, a nitride, a carbonitride, a carbo-oxide, a carbo-oxinitride or a boronitride of Ti.

EP 1643012A discloses a method for high speed machining of a metallic work piece at a cutting speed of 800-1500 m/min, a cutting depth of 2-4 mm, and a feed rate of 0.3-0.7 mm/rev with a coated cemented carbide cutting tool. The cutting tool comprises a coating as a monolayer or multiple layers with a total thickness of 25-75 µm and a cemented carbide body with hardness of >1600HV3, preferably over 1700HV3. The best results are obtained in machining of grey cast iron.

JP2004181618 discloses a cutting tool insert comprising a cermet body comprising more than 50 wt-% Ti-based carbonitride and Co and/or Ni between 6 and 15 wt-%. On the cutting tool a multilayer coating is deposited, the coating comprising TiN, TiCN, TiCO and/or TiCNO and at least one Al2O3-layer, the total thickness of the layers being between 10 and 35 µm.

It is therefore an object of the present invention to provide a cutting tool insert excellent in high efficiency cutting of nodular cast iron (NCI) and compact graphite iron (CGI).

It has now surprisingly been found that a cutting tool insert comprising a thick coating and a cermet body is excellent in high efficiency cutting of various cast irons, such as nodular cast iron (NCI), compact graphite iron (CGI) and grey cast iron (GCI), preferably machining of nodular cast iron (NCI) and compact graphite cast iron (CGI). The coating is deposited using conventional CVD or MT-CVD-techniques known in the art.
Fig 1 shows an edge of an insert in cross section provided with a coating according to the present invention.
Fig 2 shows in greater magnification a coating and adjacent cermet body according to the present invention.
Fig 3 shows in greater magnification the microstructure of the cermet body.

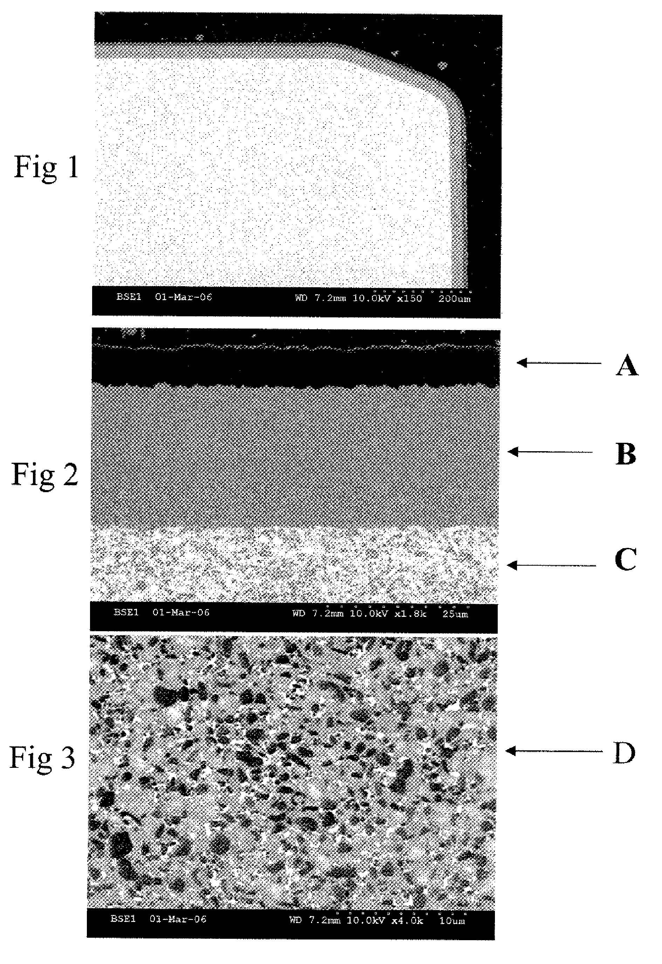

In fig 2 and 3:
A - Al₂O₃
B - Ti(C,N)-layer including bonding and transition layers
C - cermet body
D - cermet body

The present invention according to claim 1 relates to a cutting tool insert comprising a cermet body comprising Ti-based carbonitride in a Co and/or Ni binder phase and a coating deposited as a monolayer or as multiple and/or alternating layers of carbide, nitride or oxide or solid solutions or mixtures thereof, by CVD- and/or MTCVD-methods. The coating has a thickness of 21-50 µm, preferably 25-50 µm, more preferably 30-50 µm and most preferably 35-50 µm when the inserts have a flat rake face, with or without simple chipbreakers with a Co-binder phase or a thickness of 10-50 µm, preferably 15-50 µm, more preferably 21-50 µm and most preferably 30-50 µm when the inserts have a rake face land with a width of 100-300 µm with an angle of 10-25° to the rake face with a Co and/or Ni binder phase.

The cermet insert body consists of a conventional cermet body based, more than 50 vol%, on a cubic Ti-based carbonitride phase and a binder phase of Co and/or Ni, preferably Co, and at least one of W or Mo. Further elements, which may be present in the cermet body, are those conventionally used in cermet cutting tools such as Ta, Nb, V, Zr, Hf, Cr. The binder phase content is less than 15 wt%, preferably less than 13 wt%, most preferably less than 10 wt%, but more than 6.0 wt%. The grain size of the Ti-comprising carbonitride phase is 0.5-4 µm, preferably 1-3 µm. The cermet body has a hardness of >1650 HV3, preferably >1750 HV3, most preferably >1775 HV3. Hardness HV3 means Vickers hardness measured at 3 kg weight.

According to the first embodiment of claim 1 coating consists of a first layer adjacent to the cermet body with a thickness of more than 24 µm but less than 45 µm, including at least one of carbide, nitride, carbonitride or carboxynitride of one or more of Ti, Zr and Hf or mixtures thereof and a second layer of Al₂O₃ with a thickness of more than 4 µm, preferably more than 5 µm, most preferably more than 15 µm but less than 44 µm, preferably less than 25 µm, adjacent to the first layer.

In a further preferred embodiment, the coating consists of four layers:
a first layer adjacent the cermet body, the first layer including a carbide, nitride, carbonitride or carboxynitride of one or more of Ti, Zr and Hf or mixtures thereof with a thickness of 6-30 µm, preferably 6-15 µm,
an α-alumina layer adjacent said first layer with a thickness of 5-30 µm, preferably 5-15 µm
a further layer adjacent the alumina layer, the further layer including a carbide, nitride, carbonitride or carboxynitride of one or more of the metals Ti, Zr and Hf or mixtures or multilayers thereof with a thickness of 3-30 µm, preferably 4-15 µm and
a further α-alumina layer adjacent said further layer with a thickness of 3-40 µm, preferably 4-20 µm. Preferably, the first layer and/or the further layer contain Ti(C,N) with columnar.

In case of the presence of Ni in the cermet body, it is suitable to have a thin interlayer consisting of Ti(C,O) close to the cermet body, less than 2 µm thick in order to stop the Ni diffusion into the coating.

Preferably the top layer is a 4-44 µm, preferably 5-25 µm, thick Al₂O₃-layer or a <2 µm thick TiN-layer. This TiN layer can be mechanically removed by known techniques from the rake face. In such case, this outermost layer on the rake face is Al₂O₃ and on the clearance faces TiN. Mechanical removal of the TiN-layer is performed by known methods, such as blasting treatment using hard particles.

In some specific embodiments one or more friction reducing layer(s) such as layers of sulphides of tungsten and/or molybdenum may be applied as an outermost layer.

The present invention also relates to the use of a coated cutting tool insert according to above for the machining of cast iron work pieces, such as nodular cast iron (NCI), compact graphite iron (CGI) and grey cast iron (GCI). at a cutting speed of >300 m/min, preferably 400-1000 m/min and most preferably 600-1000 12193EP_2016-04-26_12193EP page 4 m/min, at a cutting depth of 2-8 mm and a feed rate of 0.2-0.7 mm/rev. The size of the cutting depth is selected with respect to the size of the cutting inserts. For smaller inserts the cutting depth is 2-4 mm and for larger ones 2-8 mm.

### EXAMPLE 1

Cermets and cemented carbide substrates A-D with chemical compositions according to Table 1 were produced in the conventional way from powders, which were milled, pressed and sintered with or without subsequent grinding to insert shapes, ISO standard CNMA120416 T02020, CNMA120416-KR and CNMA160616 T02520 and CNMA160616KR. Furthermore the inserts were subjected to mechanical edge honing.

After that the inserts were cleaned and coated using processes known in the art. Coating compositions and thicknesses appear from Table 2. Two or four layers comprising Ti(C,N) and α-Al₂O₃ were deposited. Ti(C,N) was deposited so that a columnar grain structure of the layer was obtained. This was done by using the known MT-CVD process (MT-medium temperature, CVD-chemical vapour deposition) where, besides other gases, acetonitrile, CH₃CN, was used as nitrogen and carbon source. The top of alumina layer was coated with a TiN layer.

In the start of the coating process, at the transition zone between the Ti(C,N) and Al₂O₃ layers and at the end of the Al₂O₃ coating process, conventional processes were also used. These conventional processes resulted in the formation of <2 µm thick transition, bonding or outermost layers of TiN, Ti(C,O) and/or Ti(C,N,O).

The outermost coating was a <2 µm thick TiN layer, which was mechanically removed from the inserts rake face by known Al₂O₃ particle blasting technique. Thus the outermost layer on the rake face is Al₂O₃ and on the flank side is TiN. Furthermore the blasting treatment has resulted in smoother surface topography on treated surfaces.

**TABLE 1**

| Chemical composition of the substrates grades in wt-% | | | | | | | | | |
|---|---|---|---|---|---|---|---|---|---|
| Substrate | | | | | | | | | |
| Grade | Co | Cr | Ta | Nb | Ti | W | C | N | Hardness HV(3kg) |
| A | 9.4 | - | - | 8.8 | 48.2 | 18.1 | 9.1 | 6.4 | 1800 |
| B | 12.9 | - | 18.3 | - | 40.1 | 15.5 | 7.7 | 5.5 | 1730 |
| C | 5.2 | 0.2 | - | - | - | 88.7 | 5.9 | - | 1775 |
| D | 17.9 | - | - | 9.9 | 42.2 | 16.2 | 5.7 | 8.1 | 1575 |

**TABLE 2**

| Composition and thickness of the layers. | | | | | |
|---|---|---|---|---|---|
| Coating No | CVD-layer* Ti (C, N) ** µm | CVD α Al₂O₃ µm | CVD Ti(C,N) ** µm | CVD α Al₂O₃ µm | Total thickness *** µm |
| 1 | 7.5 | 11.1 | 7.6 | 9.0 | 35.2 |
| 2 | 24.0 | 6.0 | - | - | 30,0 |
| 3 | 10.0 | 20.4 | - | - | 30.4 |
| 4 | 40.5 | 6.1 | - | - | 46.6 |
| 5 | 8.0 | 7.0 | - | - | 15.0 |

| | | | | | |
|---|---|---|---|---|---|
| *- CVD layer, closest to the substrate. **- Ti(C,N) layers thicknesses includes also thickness of bonding and transition layers, TiN, TiCO. *** - total coating thickness including Ti(C,N) and Al₂O₃ layers, bonding layers, transition layers and top layers. | | | | | |

### EXAMPLE 2

Inserts of style CNMA120416 T02020, have a rake face land with a width of 200 µm with an angle of 20° to the rake face, with an edge honing of 30 µm (as measured on the uncoated insert) with substrates A, B, C, D with coatings 1, 2, 3, 4, 5 designated A/1, A/2, A/3, A/4, A5, B5,C/2, C/3, D5 were subjected to a cutting test, an external turning operation comprising packages of 4 discs of a nodular cast iron (NCI), comprising cast skin. The discs had a diameter of 250 mm and they were machined down to a diameter of 120 mm by repeated passes. The flank wear width of the cutting edge after machining 32 discs packages was measured. As a reference was also used commercially available Si₃N₄ ceramic insert with the same geometry.

**Machining data**

| | |
|---|---|
| Workpiece: | SS0727, nodular cast iron (NCI). |
| Type of operation: | external turning operation. |
| Cutting speed: | 600 m/min |
| Depth of cut: | 3 mm. |
| Feed: | 0.35 mm/rev. |
| Coolant: | dry operation. |

**RESULTS:**

| Insert | Discs packages No | wear (Vb-mm) | comment |
|---|---|---|---|
| A/1 invention | 32 | 0.27 | even wear |
| A/2 invention | 32 | 0.30 | even wear |
| A/3 comparative | 32 | 0.37 | even wear |
| A/4 invention | 32 | 0.23 | even wear |
| A/5 comparative | 32 | 0.43 | even wear |
| B/5 comparative | 32 | 0.46 | even wear |
| C/2 prior art | 32 | 0.66 | uneven wear |
| C/3 prior art | 17 | 0.55 | chipping |
| D/5 comparative | 12 | 0.75 | plast.deform. |
| Si₃N₄ ceramic, pr. art | 20 | 0.82 | uneven wear |

### EXAMPLE 3

Example 3 was performed with inserts A/3, A/4, C/3, D5 being produced in the same way as that in Example 2. The insert geometry was CNMA120416-KR, having a flat rake face, with an edge honing of 40 µm (as measured on the uncoated insert). The cutting tests including external turning operation in grey cast iron comprising packages of 4 discs with diameter of 250 mm, which were machined down to a diameter of 120 mm by repeated passes. The flank wear width of the cutting edge after machining 32 discs packages was measured. As a reference was also used commercially available Si₃N₄ ceramic insert with the same geometry.

**Cutting data**

| | |
|---|---|
| Workpiece: | SS0125, grey cast iron (GCI). |

12193EP_2016-04-26_12193EP new pages 7-9

**Type of operation: external turning operation.**

| | |
|---|---|
| Cutting speed: | 850 m/min. |
| Depth of cut: | 3 mm. |
| Feed: | 0.35 mm/rev. |
| Coolant: | dry operation. |

**RESULTS:**

| Insert | Discs package No | wear (Vb-mm) | comment |
|---|---|---|---|
| A/3 comparative | 32 | 0.40 | even wear |
| A/4 invention | 32 | 0.26 | even wear |
| C/3 prior art | 25 | 0.61 | uneven wear |
| D/5 comparative | 8 | 0.80 | plast.deform. |
| Si₃N₄ ceramic pr.art | 32 | 0.23 | even wear |

### EXAMPLE 4

Example 4 was performed with inserts A/2, A/3, A/4, C/3, B5, D5, being produced in the same way and having the same geometry as that in Example 2. The cutting tests including external turning operation in compact graphite iron,(CGI), comprising packages of 4 discs with diameter of 250 mm, which were machined down to a diameter of 120 mm by repeated passes. The flank wear width of the cutting edge after machining 32 disc packages was measured.

**Cutting data**

| | |
|---|---|
| Workpiece: | Compact graphite iron (CGI). |
| Type of operation: | external turning operation. |
| Cutting speed: | 700 m/min) |
| Depth of cut: | 3 mm. |
| Feed: | 0.35 mm/rev. |
| Coolant: | dry operation. |

**RESULTS:**

| Insert | Discs package No | wear (Vb-mm) | comment |
|---|---|---|---|
| A/2 invention | 32 | 0.32 | even wear |
| A/3 comparative | 32 | 0.39 | even wear |
| A/4 invention | 32 | 0.29 | even wear |
| B/5 comparative | 32 | 0.48 | even wear |
| C/3 prior art | 23 | 0.60 | uneven wear |
| D/5 comparative | 10 | 0.70 | plast.deform. |

12193EP_2016-04-26_12193EP new pages 7-9

### EXAMPLE 5

Inserts of style CNMA160616 T02520, having a rake face land with a width of 250 µm with an angle of 20° to the rake face and an edge honing of 30 µm (as measured on the uncoated insert) with substrates A, B, C, D with coatings 1, 2, 3, 4, 5 designated A/2, A/3, A/4, A5, B5, C/2, D5 were subjected to a cutting test, an external turning operation comprising package of 4 discs of a nodular cast iron (NCI), comprising cast skin. The discs had a diameter of 250 mm and they were machined down to a diameter of 120 mm by repeated passes. The flank wear width of the cutting edge after machining 48 discs packages was measured. As a reference was also used commercially available Si₃N₄ ceramic insert with the same geometry.

**Machining data**

| | |
|---|---|
| Workpiece: | SS0727, nodular cast iron (NCI). |
| Type of operation: | external turning operation. |
| Cutting speed: | 600 m/min |
| Depth of cut: | 6 mm. |
| Feed: | 0.40 mm/rev. |
| Coolant: | dry operation. |

**RESULTS:**

| Insert | Discs packages No | wear (Vb-mm) | comment |
|---|---|---|---|
| A/2 invention | 48 | 0.32 | even wear |
| A/3 comparative | 48 | 0.36 | even wear |
| A/4 invention | 48 | 0.26 | even wear |
| A/5 comparative | 48 | 0.42 | even wear |
| B/5 comparative | 48 | 0.45 | even wear |
| C/2 prior art | 48 | 0.66 | uneven wear |
| D/5 comparative | 22 | 0.80 | plast.deform. |
| Si₃N₄ ceramic, pr. art | 18 | 0.74 | uneven wear |

From Examples 2-5, it is evident that if the Co content in the cermet body is too high, as in (D/5), plastic deformation of the cutting edge will occur during cutting operation having negative influence on the tool performance.

The chipping observed in Example 2, insert C/3 (prior art), having a coating on a WC-Co based cemented carbide body is 12193EP_2016-04-26_12193EP new pages 7-9 suspected to be related to CVD-cooling cracks present in the coating. Such cracks can cause local crack related flaking of the coating resulting in early reactions between the work piece and the cemented carbide. No CVD- cooling cracks are present in coatings on cermet bodies.

From Examples 2-4 it is also evident that thicker CVD coatings on cermet bodies compared to thinner ones result in an increase of the cutting tool wear resistance.

It is surprising that, in spite of the known brittleness of cermets, thick CVD coatings can be used on cermet bodies with strong edge geometry and thus improve tool wear resistance at high productivity machining using large cutting depths without edge fracture.

## Claims

1. Cutting tool insert comprising a cermet body comprising a Co and/or Ni binder phase and a coating deposited as monolayer or as multiple and/or alternating layers of carbide, nitride or oxide deposited by CVD- and/or MTCVD-methods, **characterized in that**
said cermet body comprising more than 50 vol% Ti-based carbonitride and less than 15 wt%, but more than 6 wt% Co and/or Ni binder phase and that said cermet body has a hardness, measured as Vickers Hardness at 3kg load, HV3, of >1650 HV3, and that, and
said coating has a thickness of 30-50 µm, the inserts have a flat rake face, without or with simple chipbreakers and a Co binder phase, or, a thickness of 30-50 µm, the inserts have a rake face land with a width of 100-300 µm with an angle of 10-25° to the rake face and a Co and/or Ni binder phase, and
the coating consists of adjacent to the cermet body a first layer with a thickness of more than 24
µm, but less than 45 µm, including at least one of carbide, nitride, carbonitride or carboxynitride of one or more of Ti, Zr and Hf or mixtures thereof and a second layer of Al₂O₃ with a thickness of more than 4 µm, but less than 44 µm, adjacent to the first layer, or
the coating comprises a first layer adjacent the cermet body, the first layer including a carbide, nitride, carbonitride or carboxynitride of Ti, or Zr or Hf with a thickness of 6-30 µm, an α-alumina layer adjacent said first layer with a thickness of 5-30 µm, a further layer adjacent the alumina layer, the further layer including a carbide, carbonitride or carboxynitride of one or more of the metals Ti, Zr and Hf or mixtures thereof with a thickness of 3-30 µm, and a further α-alumina layer adjacent said further layer with a thickness of 3-40 µm.

2. Cutting tool insert according to claim 1, **characterized in that** the cermet body comprises less than 10 wt% Co and/or Ni binder phase.

3. Cutting tool insert according to any one of the preceding claims, **characterized in that** the cermet body has a hardness, measured as Vickers Hardness at 3kg load, HV3, of >1775 HV3.

4. Cutting tool insert according to any one of the preceding claims, **characterized in that** the grain size of the Ti-based carbonitride phase is 0.5-4 µm.

5. Cutting tool insert according to any one of the preceding claims, **characterized in that** when the coating consists of adjacent to the cermet body a first layer with a thickness of more than 20 µm, but less than 45 µm, including at least one of carbide, nitride, carbonitride or carboxynitride of one or more of Ti, Zr and Hf or mixtures thereof and a second layer of Al₂O₃ with a thickness of more than 4 µm, but less than 44 µm, adjacent to the first layer, then the second layer of Al₂O₃ is an α-Al₂O₃ layer.

6. Cutting tool insert according to claim 5, **characterized in that** the second layer of Al₂O₃ has a thickness of more than more than 15 µm.

7. Cutting tool insert according to any one of claims 5-6, **characterized in that** the first layer comprises Ti(C,N).

8. Cutting tool insert according to any one of claims 1-4, **characterized in** a top layer of 4-44 µm Al₂O₃.

9. Cutting tool insert according to any one of claims 1-4 **characterized in** a top layer of 5-25 µm Al₂O₃.

10. Cutting tool insert according to any one of claims 1-4 **characterized in** a less than 2 µm thick top layer of TiN.

11. Cutting tool insert according to claim 10 **characterized in that** the thin TiN-layer is the outermost layer on the clearance faces and the outermost layer on the rake face is Al₂O₃.

12. Use of a coated cutting tool insert according to claims 1-11 for the machining of cast iron work pieces such as nodular cast iron (NCI), compact graphite iron (CGI) and grey cast iron (GCI) at a cutting speed of >300 m/min, at a cutting depth of 2-8 mm and a feed of 0.2-0.7 mm/rev.

## Patentansprüche

1. Schneidwerkzeugeinsatz, mit einem Cermet Körper, einer Co- und/oder Ni-Binderphase und einer Beschichtung, die als Monolage oder als mehrfache und/oder alternierende Lagen aus Carbiden, Nitriden oder Oxiden durch CVD- und/oder MTCVD-Verfahren abgeschieden ist, **gekennzeichnet dadurch, dass**
der Cermet Körper mehr als 50 Vol.-% Ti basiertes Carbonitrid und weniger als 15 Gew.-%, aber mehr als 6 Gew.-% Co- und/oder Ni-Binderphase aufweist, und, dass der Cermet Körper eine Härte von >1650 HV3 hat, gemessen als Vickers Härte HV3 mit einer Belastung von 3 kg, und dass
die Beschichtung eine Dicke von 30-50 µm hat, wobei die Einsätze eine flache Spanfläche ohne oder mit einfachen Spanbrechern haben und eine Co-Binderphase aufweisen, oder eine Dicke von 30-50 µm hat, wobei die Einsätze eine Spanflächenfase mit einer Breite von 100-300 µm mit einem Winkel von 10-25° zur Spanfläche haben und eine Co- und/oder Ni-Binderphase aufweisen, und
die Beschichtung angrenzend an den Cermet Körper aus einer ersten Lage mit einer Dicke von mehr als 24 µm, aber weniger als 45 µm, besteht, die mindestens eines der Carbide, Nitride, Carbonitride oder Carboxynitride von einem oder mehreren von Ti, Zr, und Hf oder Mischungen von diesen enthält, und einer zweiten Lage aus Al₂O₃ mit einer Dicke von mehr als 4 µm, aber weniger als 44 µm, besteht, die an die erste Lage angrenzt, oder
die Beschichtung angrenzend an den Cermet Körper eine erste Lage mit einem Carbid, Nitrid, Carbonitrid oder Carboxynitrid von Ti, oder Zr oder Hf und einer Dicke von 6-30 µm, aufweist, an die eine α-Aluminiumoxid Lage mit einer Dicke von 5-30 µm anschließt und an die eine weitere Aluminiumoxid-Lage angrenzt, wobei die weitere Lage ein Carbid, Carbonitrid oder Carboxynitrid von einem oder mehreren der Metalle Ti, Zr und Hf oder Mischungen von diesen enthält, mit einer Dicke von 3-30 µm, sowie eine weitere daran angrenzende α-Aluminiumoxid Lage mit einer Dicke von 3-40 µm aufweist.

2. Schneidwerkzeugeinsatz nach Anspruch 1, **gekennzeichnet dadurch, dass** der Cermet Körper weniger als 10 Gew.-% Co- und/oder Ni-Binderphase aufweist.

3. Schneidwerkzeugeinsatz nach einem der vorstehenden Ansprüche, **gekennzeichnet dadurch, dass** der Cermet Körper eine Härte von >1775 HV3 hat, gemessen als Vickers Härte HV3 mit einer Belastung von 3 kg.

4. Schneidwerkzeugeinsatz nach einem der vorstehenden Ansprüche, **gekennzeichnet dadurch, dass** die Korngröße der Ti-basierten Carbonitrid Phase 0.5-4 µm beträgt.

5. Schneidwerkzeugeinsatz nach einem der vorstehenden Ansprüche, **gekennzeichnet dadurch, dass** dann, wenn die an den Cermet Körper angrenzende erste Lage der Beschichtung, die mindestens eines der Carbide, Nitride, Carbonitride oder Carboxynitride von einem oder mehreren von Ti, Zr und Hf oder einer Mischung von diesen enthält, eine Dicke von mehr als 20 µm, aber weniger als 45 µm, aufweist, und die zweite Lage von Al₂O₃ angrenzend zur ersten Lage, ein Dicke von mehr als 4 µm, aber weniger als 44 µm, aufweist, dann die zweite Al₂O₃ Schicht eine α-Al₂O₃ Schicht ist.

6. Schneidwerkzeugeinsatz nach Anspruch 5, **gekennzeichnet dadurch, dass** die zweite Schicht aus Al₂O₃ eine Dicke von mehr als 15 µm hat.

7. Schneidwerkzeugeinsatz nach einem der Ansprüche 5-6, **gekennzeichnet dadurch, dass** die erste Schicht Ti(C,N) aufweist.

8. Schneidwerkzeugeinsatz nach einem der Ansprüche 1-4, **gekennzeichnet durch** eine oberste Schicht aus 4-44 µm Al₂O₃.

9. Schneidwerkzeugeinsatz nach einem der Ansprüche 1-4, **gekennzeichnet durch** eine oberste Schicht aus 5-25 µm Al₂O₃

10. Schneidwerkzeugeinsatz nach einem der Ansprüche 1-4, **gekennzeichnet durch** eine weniger als 2 µm dicke oberste Schicht aus TiN.

11. Schneidwerkzeugeinsatz nach Anspruch 10, **gekennzeichnet dadurch, dass** die äußerste Schicht auf der Freifläche die dünne TiN-Schicht und die äußerste Fläche auf der Spanfläche aus Al₂O₃ besteht.

12. Verwendung eines beschichteten Schneidwerkzeugeinsatzes nach den Ansprüchen 1-11 für die Bearbeitung von Gusseisenwerkzeugen wie Sphäroguss, Wurmgraphit und Grauguss bei einer Schneidgeschwindigkeit von >300 m/min, bei einer Schneidtiefe von 2-8 mm und einem Vorschub von 0.2-0.7 mm/U.

## Revendications

1. Insert d'outil de coupe comprenant un corps de cermet comprenant une phase liante de Co et/ou de Ni et un revêtement déposé sous la forme d'une monocouche ou de couches multiples et/ou alternées de carbure, de nitrure ou d'oxyde déposées par des procédés de dépôt CDV et/ou MTCVD, **caractérisé en ce que**
ledit corps de cermet comprenant plus de 50 % en volume de carbonitrure à base de Ti et moins de 15 % en poids, mais plus de 6 % en poids de phase liante de Co et/ou de Ni et **en ce que** ledit corps de cermet a une dureté, mesurée comme une dureté Vickers à une charge de 3 kg, HV3, > 1650 HV3, et **en ce que**, et
ledit revêtement a une épaisseur de 30 à 50 µm, les inserts ont une face brute plate, avec ou sans brise-copeaux simples et une phase liante de Co, ou, une épaisseur de 30 à 50 µm, les inserts ont un espace de face brute avec une largeur de 100 à 300 µm avec un angle de 10 à 25° par rapport à la face brute et une phase liante de Co et/ou de Ni, et
le revêtement consiste, à une position adjacente au corps de cermet, en une première couche d'une épaisseur supérieure à 24 µm, mais inférieure à 45 µm, incluant au moins l'un d'un carbure, d'un nitrure, d'un carbonitrure ou d'un carboxynitrure d'un ou plusieurs parmi Ti, Zr ou Hf ou des mélanges de ceux-ci et une deuxième couche de Al₂O₃ avec une épaisseur supérieure à 4 µm, mais inférieure à 44 µm, adjacente à la première couche, ou
le revêtement comprend une première couche adjacente au corps de cermet, la première couche incluant un carbure, un nitrure, un carbonitrure ou un carboxynitrure de Ti, Zr ou Hf avec une épaisseur de 6 à 30 µm, une couche d'alumine α adjacente à ladite première couche avec une épaisseur de 5 à 30 µm, une autre couche adjacente à la couche d'alumine, l'autre couche incluant un carbure, un nitrure, un carbonitrure ou un carboxynitrure d'un ou plusieurs des métaux Ti, Zr ou Hf ou de mélanges de ceux-ci avec une épaisseur de 3 à 30 µm, et une autre couche d'alumine α adjacente à ladite autre couche avec une épaisseur de 3 à 40 µm.

2. Insert d'outil de coupe selon la revendication 1, **caractérisé en ce que** le corps de cermet comprend moins de 10 % en poids de phase liante de Co et/ou de Ni.

3. Insert d'outil de coupe selon l'une quelconque des revendications précédentes, **caractérisé en ce que** le corps de cermet a une dureté, mesurée comme une dureté Vickers à une charge de 3 kg, HV3, > 1775 HV3.

4. Insert d'outil de coupe selon l'une quelconque des revendications précédentes, **caractérisé en ce que** la taille de grain de la phase de carbonitrure à base de Ti est de 0,5 à 4 µm.

5. Insert d'outil de coupe selon l'une quelconque des revendications précédentes, **caractérisé en ce que** lorsque le revêtement consiste, à une position adjacente au corps de cermet, en une première couche avec une épaisseur supérieure à 20 µm, mais inférieure à 45 µm, incluant au moins l'un d'un carbure, d'un nitrure, d'un carbonitrure ou d'un carboxynitrure d'un ou plusieurs parmi Ti, Zr, et Hf ou des mélanges de ceux-ci et une deuxième couche de Al₂O₃ avec une épaisseur supérieure à 4 µm, mais inférieure à 44 µm, à une position adjacente à la première couche, alors la deuxième couche de Al₂O₃ est une couche Al₂O₃ α.

6. Insert d'outil de coupe selon la revendication 5, **caractérisé en ce que** la deuxième couche de Al₂O₃ a une épaisseur supérieure à 15 µm.

7. Insert d'outil de coupe selon l'une quelconque des revendications 5 à 6, **caractérisé en ce que** la première couche comprend du Ti(C, N).

8. Insert d'outil de coupe selon l'une quelconque des revendications 1 à 4, **caractérisé par** une couche supérieure de 4 à 44 µm de Al₂O₃.

9. Insert d'outil de coupe selon l'une quelconque des revendications 1 à 4 **caractérisé par** une couche supérieure de 5 à 25 µm de Al₂O₃.

10. Insert d'outil de coupe selon l'une quelconque des revendications 1 à 4 **caractérisé par** une couche supérieure de TiN d'une épaisseur inférieure à 2 µm.

11. Insert d'outil de coupe selon la revendication 10 **caractérisé en ce que** la couche de TiN mince est la couche extérieure sur les faces de dépouille et la couche extérieure sur la face brute est Al₂O₃.

12. Utilisation d'un insert d'outil de coupe revêtu selon les revendications 1 à 11 pour l'usinage de pièces de fonte telles qu'une fonte nodulaire (NCl), une fonte à graphite compacte (CGI) et une fonte grise (GCI), à une vitesse de coupe > 300 m/min, à une profondeur de coupe de 2 à 8 mm et une avance de 0,2 à 0,7 mm/tour.
